# EUROPÄISCHE PATENTANMELDUNG

(11) **EP 3 477 173 A1**
(43) Veröffentlichungstag der Anmeldung: **01.05.2019**
(21) Anmeldenummer: 17199112.8
(22) Anmeldetag: 30.10.2017
(51) Int. Cl.: F16K 37/00, F16K 51/02

(54) **ERWEITERTE VAKUUMPROZESSSTEUERUNG**

(71) Anmelder: VAT Holding AG, 9469 Haag (CH)
(72) Erfinder: ZICKAR, Michael, CH-9032 Engelburg (CH)
(74) Vertreter: Kaminski Harmann

(57) **Zusammenfassung**

Vakuumprozesssystem zur definierten Bearbeitung eines Objekts, mit einem evakuierbares Vakuumprozessvolumen (1), einem Vakuumventil (10), einer zur zumindest teilweisen Bereitstellung eines definierten Prozesszustandes ausgebildete Periphereinheit (4,21-25) und einer Regel- und Steuerungseinheit (11). Das Vakuumventil (10) weist einen Ventilsitz, der eine eine Öffnungsachse definierende Ventilöffnung und eine die Ventilöffnung umlaufende erste Dichtfläche aufweist, einen Ventilverschluss mit einer zweiten zu der ersten Dichtfläche korrespondierenden Dichtfläche und eine mit dem Ventilverschluss gekoppelte Antriebseinheit, die derart ausgebildet ist, dass der Ventilverschluss zur Bereitstellung eines jeweiligen Ventilöffnungszustands definiert variierbar und einstellbar ist. Die Regel- und Steuerungseinheit (11) ist zur mehrfachen Ausführung eines Prozesszyklus ausgebildet, mit einer derartigen Ansteuerung der Periphereinheit (4,21-25), dass zumindest ein Teil des definierten Prozesszustands bereitstellbar ist, und einer Ausführung eines eine gezielte Variation bzw. Einstellung des Ventilöffnungszustands bereitstellenden Regelzyklus durch Ansteuerung der Antriebseinheit basierend auf einer aktuell bestimmten Regelgrösse für einen Prozessparameter und basierend auf einer Zielgrösse. Die Ansteuerung der Periphereinheit (4,21-25) und die Ausführung des Regelzyklus im Rahmen des Prozesszyklus sind mit einer bestimmten zeitlichen Relation durchführbar.

## Beschreibung

Die Erfindung betrifft ein System aus einem Vakuumventil, einer Prozesskammer, einer Periphereinheit und einer Steuer- und Regeleinheit für den gesteuerten und geregelten Betrieb eines Bearbeitungsprozesses unter Vakuumbedingungen.

Allgemein sind Vakuumventile zur Regelung eines Volumen- oder Massenstroms und zum im Wesentlichen gasdichten Schliessen eines Fliesswegs, der durch eine in einem Ventilgehäuse ausgeformte Öffnung führt, in unterschiedlichen Ausführungsformen aus dem Stand der Technik bekannt und kommen insbesondere bei Vakuumkammersystemen im Bereich der IC-, Halbleiter- oder Substratfertigung, die in einer geschützten Atmosphäre möglichst ohne das Vorhandensein verunreinigender Partikel stattfinden muss, zum Einsatz. Derartige Vakuumkammersysteme umfassen insbesondere mindestens eine zur Aufnahme von zu bearbeitenden oder herzustellenden Halbleiterelementen oder Substraten vorgesehene, evakuierbare Vakuumkammer, die mindestens eine Vakuumkammeröffnung besitzt, durch welche die Halbleiterelemente oder anderen Substrate in die und aus der Vakuumkammer führbar sind, sowie mindestens eine Vakuumpumpe zum Evakuieren der Vakuumkammer. Beispielsweise durchlaufen in einer Fertigungsanlage für Halbleiter-Wafer oder Flüssigkristall-Substrate die hochsensiblen Halbleiter- oder Flüssigkristall-Elemente sequentiell mehrere Prozess-Vakuumkammern, in denen die innerhalb der Prozess-Vakuumkammern befindlichen Teile mittels jeweils einer Bearbeitungsvorrichtung bearbeitet werden. Sowohl während des Bearbeitungsprozesses innerhalb der Prozess-Vakuumkammern, als auch während des Transports von Kammer zu Kammer müssen sich die hochsensiblen Halbleiterelemente oder Substrate stets in geschützter Atmosphäre - insbesondere in luftleerer Umgebung - befinden.

Hierfür kommen zum einen Peripherieventile zum Öffnen und Schliessen einer Gaszu- oder -abfuhr und zum anderen Transferventile zum Öffnen und Schliessen der Transferöffnungen der Vakuumkammern für das Ein- und Ausführen der Teile zum Einsatz.

Die von Halbleiterteilen durchlaufenen Vakuumventile werden aufgrund des beschriebenen Anwendungsgebiets und der damit verbundenen Dimensionierung als Vakuum-Transferventile, aufgrund ihres mehrheitlich rechteckigen Öffnungsquerschnitts auch als Rechteckventil und aufgrund ihrer üblichen Funktionsweise auch als Schieberventil, Rechteckschieber oder Transferschieberventil bezeichnet.

Peripherieventile werden insbesondere zur Steuerung oder Regelung des Gasflusses zwischen einer Vakuumkammer und einer Vakuumpumpe oder einer weiteren Vakuumkammer eingesetzt. Peripherieventile befinden sich beispielsweise innerhalb eines Rohrsystems zwischen einer Prozess-Vakuumkammer oder einer Transferkammer und einer Vakuumpumpe, der Atmosphäre oder einer weiteren Prozess-Vakuumkammer. Der Öffnungsquerschnitt derartiger Ventile, auch Pumpenventile genannt, ist in der Regel kleiner als bei einem Vakuum-Transferventil. Da Peripherieventile abhängig vom Einsatzgebiet nicht nur zum vollständigen Öffnen und Schliessen einer Öffnung, sondern auch zum Steuern oder Regeln eines Durchflusses durch kontinuierliches Verstellen des Öffnungsquerschnitts zwischen eine vollständigen Offenstellung und einer gasdichten Geschlossenstellung eingesetzt werden, werden sie auch als Regelventile bezeichnet. Ein mögliches Peripherieventil zur Steuerung oder Regelung des Gasflusses ist das Pendelventil.

Bei einem typischen Pendelventil, wie beispielsweise aus der US 6,089,537 (Olmsted) bekannt, wird in einem ersten Schritt ein in der Regel runder Ventilteller über eine in der Regel ebenfalls runde Öffnung von einer die Öffnung freigebenden Stellung in eine die Öffnung überdeckende Zwischenstellung rotatorisch geschwenkt. Im Falle eines Schieberventils, wie beispielsweise in der US 6,416,037 (Geiser) oder der US 6,056,266 (Blecha) beschrieben, ist der Ventilteller, wie auch die Öffnung, meist rechteckig ausgebildet und wird in diesem ersten Schritt linear von einer die Öffnung freigebenden Stellung in eine die Öffnung überdeckende Zwischenstellung geschoben. In dieser Zwischenstellung befindet sich der Ventilteller des Pendel- oder Schieberventils in einer beabstandeten Gegenüberlage zu dem die Öffnung umgebenden Ventilsitz. In einem zweiten Schritt wird der Abstand zwischen dem Ventilteller und dem Ventilsitz verkleinert, so dass der Ventilteller und der Ventilsitz gleichmässig aufeinander gedrückt werden und die Öffnung im Wesentlichen gasdicht verschlossen wird. Diese zweite Bewegung erfolgt vorzugsweise im Wesentlichen in eine senkrechte Richtung zum Ventilsitz. Die Abdichtung kann z.B. entweder über einen auf der Verschlussseite des Ventiltellers angeordneten Dichtungsring, der auf den die Öffnung umlaufenden Ventilsitz gepresst wird, erfolgen, oder über einen Dichtungsring auf dem Ventilsitz, gegen den die Verschlussseite des Ventiltellers gedrückt wird. Durch den in zwei Schritten erfolgenden Schliessvorgang wird der Abdichtring zwischen dem Ventilteller und dem Ventilsitz kaum Scherkräften, die den Abdichtring zerstören würden, unterworfen, da die Bewegung des Ventiltellers im zweiten Schritt im Wesentlichen geradlinig senkrecht auf den Ventilsitz stattfindet.

Unterschiedliche Dichtvorrichtungen sind aus dem Stand der Technik bekannt, beispielsweise aus der US 6,629,682 B2 (Duelli). Ein geeignetes Material für Dichtungsringe und Dichtungen bei Vakuumventilen ist beispielsweise Fluorkautschuk, auch FKM genannt, insbesondere das unter dem Handelsnamen "Viton" bekannte Fluorelastomer, sowie Perfluorkautschuk, kurz FFKM.

Aus dem Stand der Technik sind unterschiedliche Antriebssysteme zur Erzielung diese Kombination einer beim Pendelventil rotatorischen und beim Schieberventil translatorischen Bewegung des Ventiltellers parallel über die Öffnung und einer im Wesentlichen translatorischen Bewegung senkrecht auf die Öffnung bekannt, beispielsweise aus der US 6,089,537 (Olmsted) für ein Pendelventil und aus der US 6,416,037 (Geiser) für ein Schieberventil.

Das Anpressen des Ventiltellers auf den Ventilsitz muss derart erfolgen, dass sowohl die geforderte Gasdichtigkeit innerhalb des gesamten Druckbereichs sichergestellt ist, als auch eine Beschädigung des Abdichtmediums, insbesondere des Abdichtrings in Form eines O-Rings, durch zu grosse Druckbeanspruchung vermieden wird. Um dies zu gewährleisten, sehen bekannte Ventile eine in Abhängigkeit von der zwischen den beiden Ventiltellerseiten herrschenden Druckdifferenz geregelte Anpressdruckregelung des Ventiltellers vor. Besonders bei grossen Druckschwankungen oder dem Wechsel von Unterdruck auf Überdruck, oder umgekehrt, ist eine gleichmässige Kraftverteilung entlang des gesamten Umfangs des Abdichtrings jedoch nicht immer gewährleistbar. Generell wird angestrebt, den Abdichtring von Abstützkräften, die sich aus dem an das Ventil anliegenden Druck ergeben, zu entkoppeln. In der US 6,629,682 (Duelli) wird hierzu z.B. ein Vakuumventil mit einem Abdichtmedium vorgeschlagen, das sich aus einem Abdichtring und einem danebenliegenden Abstützring zusammensetzt, so dass der Abdichtring von Abstützkräften im Wesentlichen befreit ist.

Um die geforderte Gasdichtigkeit, gegebenenfalls sowohl für Über- als auch Unterdruck, zu erreichen, sehen zusätzlich oder alternativ zum zweiten Bewegungsschritt manche bekannte Pendelventile oder Schieberventile einen senkrecht zum Ventilteller verschiebbaren, die Öffnung umgebenden Ventilring vor, der zum gasdichten Schliessen des Ventils auf den Ventilteller gedrückt wird. Derartige Ventile mit relativ zum Ventilteller aktiv verschiebbaren Ventilringen sind beispielsweise aus der DE 1 264 191 B1, der DE 34 47 008 C2, der US 3,145,969 (von Zweck) und der DE 77 31 993 U bekannt. In der US 5,577,707 (Brida) wird ein Pendelventil mit einem eine Öffnung aufweisenden Ventilgehäuse und einem parallel über die Öffnung schwenkbaren Ventilteller zum Steuern eines Durchflusses durch die Öffnung beschrieben. Ein Ventilring, der die Öffnung umschliesst, ist senkrecht in Richtung zum Ventilteller mittels mehrerer Federn und Druckluftzylinder aktiv bewegbar. Eine mögliche Weiterentwicklung dieses Pendelventils wird in der US 2005/0067603 A1 (Lucas et al.) vorgeschlagen.

Da oben genannte Ventile unter anderem bei der Herstellung hochsensibler Halbleiterelemente zum Einsatz kommen, muss die insbesondere durch die Betätigung des Ventils und durch die mechanische Belastung des Ventilverschlussgliedes verursachte Partikelgenerierung und die Anzahl der freien Partikel im Ventilraum möglichst gering gehalten werden. Die Partikelgenerierung ist primär eine Folge von Reibung beispielsweise durch Metall-Metall-Kontakt und durch Abrasion.

Wie oben beschrieben werden Vakuumregelventile zur Einstellung einer definierten Prozessumgebung in einer Prozesskammer eingesetzt. Die Regelung erfolgt hier typischerweise anhand eines Drucksignals, welches eine Information über den Kammerinnendruck bereitstellt, und anhand einer Zielgrösse, d.h. eines Solldrucks, die mittels der Regelung erreicht werden soll. Die Stellung eines Ventilverschlusses (Ventilteller) wird dann im Rahmen der Regelung so variiert, dass innerhalb eines bestimmten Zeitraums der Solldruck erreicht wird.

Alternativ zur Regelung können Vakuumregelventile auch anhand bekannter Prozessparameter, wie beispielsweise ein zu erreichender Solldruck in der Prozesskammer in einer vorgegebenen Zeit, gesteuert betrieben werden. Hierzu werden z.B. diesbezügliche Sollpositionen für den Ventilteller bereitgestellt und diese Position in ebenfalls vorgegebenen Zeiten angefahren.

Beide obigen Verfahren haben ihre spezifischen Vor- und Nachteile. So kann mittels einer vordefinierten Steuerung ein Solldruck in der Prozesskammer in verhältnismässig kurzer Zeit eingestellt werden, jedoch ist aufgrund eines typischerweise mangelnden Feedbacks (z.B. einer aktuellen Druckinformation) eine Aussage über den tatsächlich vorliegenden Druck nur unter Vorbehalt zu tätigen. Etwaige unerwünschte Einflüsse auf den Produktionsprozess, wie z.B. ein veränderter Gaseinlass oder ein Leck der Prozesskammer bleiben gänzlich unerkannt und führen dann typischerweise zu einer Verminderung der Fertigungsqualität.

In Unterschied zur Steuerung ist eine Regelung des Druckes in einer Prozesskammer zeitintensiver. Ein Feedbacksignal - typischerweise erzeugt von einem Drucksensor, der den aktuell anliegenden Kammerdruck misst - wird mit einer naturgemässen Verzögerung erfasst und verarbeitet. Eine darauf basierende Regelung erfolgt folglich mit einer entsprechenden Verzögerung und führt zu einer entsprechend späteren Einstellung des Solldrucks. Hingegen vermag die Regelung des Solldrucks diesen auch bei variierenden Gaseinlässen oder Druckschwenkungen in der Prozesskammer verlässlich einzustellen. Aufgrund der zuverlässigeren Prozesssicherheit in Hinblick auf den massgebenden Kammerinnendruck, wird in den meisten Fällen eine Regelung des Ventils bevorzugt eingesetzt.

Darüber hinaus ist ein typischer Bearbeitungsprozess aus einer Serie von einzelnen Schritten aufgebaut - Bestücken der Kammer, Verschliessen der Kammer, Evakuieren und mit Prozessgas Befüllen der Kammer etc. Zu diesen Schritten zählt insbesondere auch das Einstellen eines Solldrucks oder gewünschten Massenstroms in der Kammer mittels des Vakuumventils. Durch die typischerweise dezentrale Abstimmung der einzelnen Schritte sind Steuerungen für derartige Prozesse komplex, fehleranfällig und mit gewissen Zeitverzögerungen zwischen einzelnen Schritten behaftet. Beispielsweise bekommt ein Regelventil ein Signal wann mit der Druckregelung begonnen werden soll. Nach Erreichen des Solldrucks muss wiederum ein Signal für den darauf folgenden Prozessschritt ausgegeben werden.

Der Erfindung liegt somit die Aufgabe zugrunde, einen verbesserten Vakuumprozess bereitzustellen, welcher die oben genannten Nachteile zu überwinden vermag.

Insbesondere ist es Aufgabe der Erfindung einen verbesserten Vakuumprozess bereitzustellen, welcher ein verbessertes, d.h. schnelleres, zuverlässigeres und einfacheres, Bearbeiten von Objekten aufweist.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die grundlegende Idee der vorliegenden Erfindung ist es die Steuerung bzw. Regelung des Vakuumventils für ein solches Bearbeitungssystem nicht länger isoliert auszuführen, d.h. die Steuerung des Ventils erhält nicht mehr nur ein Signal zum Starten der Druckeinstellung, sondern eine Regel- und Steuerungseinheit für das System regelt nicht nur das Ventil sondern steuert aktiv zumindest einen weiteren Schritt und damit eine weitere Komponente des Bearbeitungsprozesses. Durch ein solche zentrale Steuerung und Regelung mehrere Komponenten kann eine verbesserte Abstimmung einzelner Prozessschritte resultieren. Beispielsweise kann ein Beginn der Druckregelung mit einer Ansteuerung eines Gaseinlassventils optimiert synchronisiert werden und dadurch ein schnelleres Einregeln auf einen gewünschten Solldruck bereitgestellt werden. Alternativ kann z.B. Regler erkennen, wann der Solldruck voraussichtlich erreicht wird, und kann eine Periphereinheit - wie eine Elektrode zur Plasmaerzeugung - entsprechend zeitoptimiert ansteuern. Auch hierdurch kann eine bedeutende Zeitersparnis ermöglicht werden.

Bei mehrfacher Wiederholung eines Prozesszyklus können weitere Vorteile des Systems ausgenutzt werden. Seitens des Vakuumventils und dessen Regelung kann beispielsweise eine Information generiert werden, die eine Aussage über den Zustand des Prozesses zulässt. Beispielsweise kann eine aktuell aufgenommene Regelkurve mit einer hinterlegten Regelkurve verglichen werden und anhand von möglichen Abweichungen dieser beider Kurven eine gesteuert Anpassung des Prozesses erfolgen. Hierzu kann beispielsweise in einem nächsten Zyklus ein Gaseinlass gesteuert reduziert werden. Einer zu lange andauernden Regelzeit kann hier z.B. entnommen werden, dass die zuvor eingelassene Gasmenge zu gross war.

Die Erfindung betrifft also ein Vakuumprozesssystem zur definierten Bearbeitung eines Objekts unter Vakuumbedingungen. Das System weist ein evakuierbares Vakuumprozessvolumen, in welches das Objekt zu dessen Bearbeitung einbringbar ist, auf, ein Vakuumventil zur Regelung eines Volumen- oder Massenstroms aus dem Vakuumprozessvolumen und/oder zum gasdichten Abschluss des Vakuumprozessvolumens, eine zur zumindest teilweisen Bereitstellung eines definierten Prozesszustandes in dem Vakuumprozessvolumen ausgebildete Periphereinheit und eine Regel- und Steuerungseinheit. Die teilweise Bereitstellung eines definierten Prozesszustandes ist derart zu verstehen, dass zumindest eine der prozessbestimmenden Grössen (z.B. Kammerdruck oder Art des Prozessgases) bereitgestellt werden kann.

Das Vakuumprozessvolumen ist beispielsweise eine Prozesskammer, die nach Bedarf gasdicht verschliessbar ist und in welche das Objekt z.B. mittels eines Roboters eingebracht und entnommen werden kann. Das Objekt kann z.B. ein zu beschichtendes Substrat oder ein Wafer (Halbleiterwafer) sein.

Die Periphereinheit kann durch diverse ansteuerbare Komponenten, die für einen Bearbeitungsprozess vorgesehene sind, gebildet werden. Insbesondere kann eine Gaseilasseinheit (z.B. Gaseinlassventil oder Verdampfer), eine Plasmavorrichtung zur Erzeugung des Plasmas oder ein Transferventil die Periphereinheit bilden. Ein Pin-Lifter kann ebenso als derartige Periphereinheit angesehen werden.

Das Vakuumventil weist einen Ventilsitz auf, der eine eine Öffnungsachse definierende Ventilöffnung und eine die Ventilöffnung umlaufende erste Dichtfläche aufweist. Zudem ist ein Ventilverschluss zum im Wesentlichen gasdichten Verschliessen der Ventilöffnung mit einer zweiten zu der ersten Dichtfläche korrespondierenden Dichtfläche vorgesehen. Das Ventil verfügt zudem über eine mit dem Ventilverschluss gekoppelte Antriebseinheit, die derart ausgebildet ist, dass der Ventilverschluss zur Bereitstellung eines jeweiligen Ventilöffnungszustands definiert variierbar und einstellbar ist und von einer Offenposition, in welcher der Ventilverschluss die Ventilöffnung zumindest teilweise freigibt in eine Schliessposition, in welcher die erste Dichtfläche auf die zweite Dichtfläche angedrückt ist und die Ventilöffnung im Wesentlichen gasdicht verschliesst, und zurück verstellbar ist.

Die Regel- und Steuerungseinheit ist zur mehrfachen Ausführung eines Prozesszyklus ausgebildet. Der Prozesszyklus umfasst zumindest eine derartige Ansteuerung der Periphereinheit, dass zumindest ein Teil des definierten Prozesszustands (z.B. definiertes Prozessgas) bereitstellbar ist, und eine Ausführung eines eine gezielte Variation bzw. Einstellung des Ventilöffnungszustands bereitstellenden Regelzyklus durch Ansteuerung der Antriebseinheit basierend auf einer aktuell bestimmten Regelgrösse für einen Prozessparameter und basierend auf einer Zielgrösse, insbesondere wodurch die Regelgrösse an die Zielgrösse durch eine so bewirkte Zustandsänderung des Ventilverschlusses annäherbar ist.

Die Ansteuerung der Periphereinheit und die Ausführung des Regelzyklus sind im Rahmen des Prozesszyklus mit einer bestimmten zeitlichen Relation durchführbar und steuerbar.

Die beiden Schritte des Ansteuerns der Periphereinheit und des Regelns mittels des Ventils können also in zeitlicher Abstimmung, d.h. mit einem bekannten und vorbestimmten zeitlichen Versatz oder synchron eingeleitet oder durchgeführt werden. Der zeitliche Versatz ist dabei abhängig von dem zu erreichenden Prozesszustand (z.B. bestimmter, konstanter Innendruck oder laminare Strömung) gewählt.

Eine Synchronisation von geregeltem Kammerdruck durch Abpumpen mit variabler Ventileinstellung und Gasinjektion mittels z.B. eines Verdampfungssystems erlaubt die Bereitstellung eines gleichmässigen Drucks oder Flusses und eine vergleichsweise schnelle Evakuierung des Volumens, z.B. nach Durchführung eines Prozessschritts und vor Einleitung eines nachfolgenden Schritts.

Ferner können gezielt gewünschte Gasmengen für die Abscheidung von Atomlage (ADL: Atomic Layer Deposition) oder das Ätzen von Oberflächen (ALE: Atomic Layer Etching) bereitgestellt werden. Hierbei sind typischerweise exakt definierte Prozesszeiten im Bereich von einigen wenigen Millisekunden einzuhalten. Eine mehrfache Wiederholung solcher Schritte mit identischem Ablauf kann für spezifische Fertigungen gefordert sein. Entscheidend kann dabei sein, dass die Prozesszeit jeweils präzise eingehalten wird, damit z.B. die Anzahl applizierter Atomlagen oder einzelner Atome konstant beibehalten werden kann und nicht zu wenige oder zu viele Lagen oder Atome abgeschieden werden. Das System gemäss der Erfindung vermag diese Prozesse in verbesserter Weise zu steuern, da sowohl die Bereitstellung der benötigten Prozessgase mittels der Periphereinheit (z.B. Verdampfer) steuerbar ist als auch die Einstellung des benötigen Kammerdrucks abgestimmt geregelt werden kann.

Eine Regelung (Closed-Loop) kann dabei deshalb von Vorteil sein, da hierdurch Drifteffekt für mögliche Systemfehler im Unterschied zu einer Open-Loop Steuerung vermieden werden können.

Durch zusätzlich Überwachungseinheiten, wie beispielsweise einem Drucksensor, kann die zeitliche Ansteuerung von Periphereinheit und Vakuumventil eingestellt bzw. optimiert werden.

In einer Ausführungsform weist die Regel- und Steuerungseinheit eine, insbesondere prozesszyklenübergreifende, Aktualisierungsfunktionalität auf, die derart ausgestaltet ist, dass bei deren Ausführung während eines ersten Prozesszyklus eine Prozessinformation abgeleitet wird und ein nachfolgender zweiter Prozesszyklus basierend auf der Prozessinformation angepasst wird. Die Prozessinformation kann z.B. eine Abweichung von einem definierten Normalzustand für den Prozess sein, beispielsweise ein übermässiger Druckanstieg bei einer Belüftung mit Prozessgas. Die Prozessinformation kann aus einem jeweiligen Regelverhalten des Ventils extrahiert werden. Als Konsequenz kann ein Ventil für den Gaseinlass bei einem nachfolgenden Prozesszyklus so angepasst angesteuert werden, dass der Druckanstieg ein Sollniveau nicht überschreitet.

Eine vormals noch auftretende Abweichung in dem Prozesszyklus kann so in einem nächsten Zyklus verringert oder gänzlich vermieden werden.

Die Regel- und Steuerungseinheit kann zudem derart konfiguriert sein, dass die Aktualisierungsfunktionalität fortlaufend, insbesondere über eine Vielzahl von Regelzyklen während eines Produktionsprozesses, ausführbar ist.

Die Prozessinformation kann in Abhängigkeit der Ausprägung der abgeleiteten Regelabweichung erzeugbar sein, insbesondere wobei die Prozessinformation erzeugt wird falls die Regelabweichung einen vorgegebenen Schwellwert überschreitet.

Die Prozessinformation kann ferner ein Ausgabesignal umfassen, wobei das Ausgabesignal akustisch oder visuell erzeugt ist. Ausserdem kann die Prozessinformation eine eine Qualität für den Regelzyklus angebende Qualitätsinformation aufweisen und anhand dieser Qualitätsinformation kann eine Benutzerausgabe, insbesondere eine Fehlerinformation oder ein Alarmsignal, erzeugbar sein.

Basierend auf der Prozessinformation kann zudem ein unerwünschter Prozesszustand identifiziert werden, insbesondere ein unerwünschter Messenzustrom während des Regelzyklus, insbesondre wobei die Existenz eines Lecks des Prozessvolumens identifizierbar ist.

Insbesondere kann durch Erfassen der Regelgrösse bei Ausführung des ersten Prozesszyklus ein Istregelverlauf als Prozessinformation abgeleitet werden, der Istregelverlauf mit einem hinterlegten Referenzregelverlauf verglichen und eine Regelabweichung (erweiterte Prozessinformation) abgeleitet werden und das Anpassen des zweiten Prozesszyklus basierend auf einer Ausprägung der abgeleiteten Regelabweichung erfolgt. Für den zweiten Prozesszyklus kann z.B. eine gesteuert anfahrbare Vorregelposition für den Ventilverschluss angepasst oder ein Startzeitpunkt für den Gaseinlass korrigiert werden.

Eine Vorregelposition kann bei einer Unterteilung des Regelzyklus in zwei Teilschritte angefahren werden. In einem ersten Teilschritt wird der Ventilverschluss gemäss einer bekannten Einstellung gesteuert in diese Position gebracht, die idealerweise bereits nahe an einer durch reine Regelung einzustellenden Position liegt. In einem zweiten Teilschritt erfolgt eine reine Einregelung des Kammerinnendrucks Durch das direkte Ansteuern der Vorregeposition kann ein Delay, der aufgrund der verzögerten Information des Drucksensors herrühren kann, überbrückt und reduziert werden.

In einer Ausführung kann durch Erfassen der Regelgrösse bei Ausführung des ersten Prozesszyklus die Prozessinformation abgeleitet werden und basierend auf der Prozessinformation die Ansteuerung der Periphereinheit für den zweiten Prozesszyklus angepasst werden. Aus einer durch ein aktuelles Regeln des Ventils ableitbaren Information über den Prozesszustand kann hierdurch der Prozess, d.h. ein nachfolgender Prozesszyklus, durch direkte Ansteuerung der Periphereinheit an die Sollvorgaben angepasst werden, d.h. ohne dass an den Regelparametern für das Regeln des Ventils eine Veränderung vorgenommen werden muss. Die Ventilregelung kann hier also auch zur Überprüfung und Überwachung des Prozesses eingesetzt werden und ausgebildet sein.

Eine basierend auf einem vorangehenden Zyklus angepasste Ansteuerung der Periphereinheit kann als (neue) aktuelle Ansteuerung für den Prozesszyklus bereitgestellt und/oder hinterlegt werden, insbesondere wobei die Anpassung der Ansteuerung der Periphereinheit basierend auf einem zumindest teilweise prognostizierbaren Effekt auf die Regelgrösse erfolgt. Hierdurch ist eine iterative Anpassung des Prozesszyklus bereitgestellt.

Insbesondere wird der zweite Prozesszyklus nachfolgend auf den ersten Prozesszyklus ausgeführt.

In einer Ausführungsform kann die Regel- und Steuerungseinheit derart ausgestaltet sein, dass der Referenzregelverlauf durch Erfassen der Regelgrösse während Ausführung einer Mehrzahl von Regelzyklen erzeugbar und hinterlegbar ist, insbesondere wobei eine Mittelung der für ein bestimmtes Zeitintervall oder für einen bestimmten Zeitpunkt des Regelschritts erfassten Regelgrössen erfolgt.

Dies kann als eine Art Lernfunktion für die Regelung verstanden werden und lässt die Generierung eines Sollregelverlaufs zu.

Ferner kann die Regel- und Steuerungseinheit eine alternative Lernfunktionalität zur Erzeugung eines Referenzprozessverlaufs aufweisen, wobei die Lernfunktionalität derart konfiguriert ist, dass bei deren Ausführung für eine Durchführung von einer Anzahl von im Wesentlichen gleichartigen Prozesszyklen entsprechend eines Sollbetriebs für den Prozesszyklus jeweilige Sollpositionen für den Ventilverschluss und/oder jeweilige Steuergrössen zur Ansteuerung der Periphereinheit über zumindest je einen Zeitabschnitt eines jeweiligen Prozesszyklus erfasst werden. Die erfassten Sollpositionen und/oder Steuergrössen können mit Bezug zu jeweiligen Zeitabschnitten des Prozesszyklus als der Referenzprozessverlauf gespeichert werden. Die Lernfunktion ist also nicht allein auf den Regelzyklus beschränkt sondern kann sämtliche Steuerbefehle betreffen, die von der Regel- und Steuerungseinheit verwaltet oder ausgegeben werden.

Hierbei sind insbesondere die jeweiligen Zeitpunkte für die Ausgabe von Steuersignalen relevant. Durch das Erlernen der jeweiligen relativen Zeitpunkte, d.h. relativ zu einem vorangehenden Steuersignal, kann eine Optimierung im Prozessablauf und damit eine Reduzierung der Prozesszeit erreicht werden.

Der Referenzregelverlauf kann in Abhängigkeit der Zielgrösse und einer zulässigen Zeitdauer für die Ausführung des Regelzyklus, insbesondere des auszuführenden Prozesszyklus, definiert sein.

Gemäss einer spezifischen Ausführungsform kann die Regel- und Steuerungseinheit zur Ausgabe eines Startsignals für die Ansteuerung der Periphereinheit und zur Einleitung des Regelzyklus mit einem definierten Zeitversatz bezüglich des Startsignals ausgebildet sein. Die ist beispielsweise von Vorteil, wenn die Periphereinheit eine steuerbarere Gaseinlasseinheit ist und mit dem Beginn des Gaseinlasses ein Regeln des Innendrucks einsetzen soll. Im Unterschied zu einer Anordnung des Standes der Technik, bei der von einer Host-Controller ein Signal für den Gaseinlass an das Ventil ausgegeben wird, und das Ventil dann ein Feedbacksignal eines Drucksensors erwartet, kann die Regelung zeitlich angepasst mit dem Gaseinlass beginnen. Insbesondere kann in einer ersten Regelphase ein gezieltes Verstellen des Ventilverschlusses erfolgen und ein reines Regeln basierend auf einer empfangenen Druckinformation im Anschluss einsetzen.

Durch die Zweistufigkeit der Zyklus setzt die Regelung beispielsweise mit einem gewissen zeitlichen Offset ein (Erzeugt durch das zuvor ablaufende gesteuerte Verstellen des Ventilverschlusses und angepasst auf den Startzeitpunkt), wodurch für die Regelung dann bereits aktuelle Druckdaten aus dem Prozessvolumen vorliegen und die Regelung so direkt einsetzen kann.

Der Prozessparameter kann insbesondere durch eine Druckinformation für das Vakuumprozessvolumen verkörpert sein. Die Zielgrösse kann ein im Vakuumprozessvolumen zu erreichender Solldruck sein und die aktuell bestimmte Regelgrösse kann einen aktuellen Druck im Vakuumprozessvolumen repräsentieren. Hierbei handelt es sich dann um eine Druckregelung für ein Prozessvolumen.

Z.B. wird in Reaktion auf einen gemessenen Druck in einer Prozesskammer ein Öffnungsquerschnitt des Ventils in eine bestimmte Richtung verstellt, wobei bei einer Vergrösserung des Querschnitts ein Druckabfall und bei einer Verkleinerung des Querschnitts ein Druckanstieg zu erwarten ist (Prognostizierbarkeit). Ist der Prozessaufbau sehr gut bekannt, kann neben der Richtung (Zunahme und Abnahme des Drucks) der Druckänderung auch ein hierdurch bewirkter Betrag der Druckänderung zumindest grob bekannt sein.

In einer Variante der Erfindung kann die Zielgrösse ein im Vakuumprozessvolumen zu erreichender Solldruck sein, wobei die aktuell bestimmte Regelgrösse - beispielsweise zusätzlich zu einer Druckinformation - einen aktuellen Medienzufluss in das Vakuumprozessvolumen angibt, insbesondere wobei die aktuell bestimmte Regelgrösse eine aktuelle Druckeinlassgrösse berücksichtigt. Mit dieser zusätzlichen Information kann eine Regelung des Solldrucks mit gesteigerter Genauigkeit und Effizienz erfolgen.

Insbesondere kann mit der aktuelle bestimmten Regelgrösse eine Austrittsinformation hinterlegt sein oder aktuell bestimmt werden, wobei die Austrittsinformation angibt, welche Masse oder welches Volumen eines Mediums (z.B. Prozessgas) pro Zeiteinheit aus dem Prozessvolumen und in Abhängigkeit der Verschlussposition abströmt. Die Austrittsinformation kann dabei massgeblich von einer von einer Vakuumpumpe bereitgestellten Absaugleistung abhängen.

Die Regel- und Steuerungseinheit kann beispielsweise mit einem Drucksensor verbunden sein, wobei ein Ausgangssignal des Drucksensors die aktuell bestimmte Regelgrösse (aktueller Druck in der Prozesskammer) bereitstellt. Alternativ oder zusätzlich kann die Regel- und Steuerungseinheit mit einem Massenströmungsmesser oder einer Massenströmungskontrolleinheit verbunden sein und ein Ausgangssignal des Massenströmungsmesser bzw. der Massenströmungskontrolleinheit stellt die aktuell bestimmte Regelgrösse (z.B. als Information über eine Zustrommenge eines Prozessgases pro Zeit) bereit. Die Regelgrösse muss im zweiten Fall also nicht der Kammerdruck sein, sondern kann auch den aktuellen Gaszufluss repräsentieren.

Vorzugsweise sind der Istregelverlauf und der Referenzregelverlauf in Form einer jeweiligen Regelkurve erfasst.

In einer Ausführungsform sind das Vakuumventil und die Regel- und Steuerungseinheit in integrierter Bauweise ausgeführt.

Alternativ kann die Regel- und Steuerungseinheit strukturell getrennt von dem Vakuumventil ausgebildet sein und in Kommunikationsverbindung mit dem Vakuumventil stehen, insbesondere wobei eine drahtlose Funkverbindung oder eine drahtgebundene Verbindung besteht.

In entsprechenden Ausführungsformen kann die Periphereinheit ausgebildet sein als
- eine Prozessgasbereitstellungseinheit, insbesondere als Verdampfer, als Gaseinlassventil oder als Massendurchflussregler,
- ein Plasmaerzeuger, insbesondere hochfrequent umpolbare Elektroden, insbesondere mit einer Frequenz von mindestens 13 MHz,
- ein Vakuumtransferventil zur Be- und Entladung des Vakuumprozessvolumens,
- eine Temperiereinheit zu Einstellung einer definierten Temperatur in der Prozesskammer oder an dem Objekt,
- eine Robotereinheit zum Transport des Objekts in und/oder aus dem Vakuumprozessvolumen,
- eine Vakuumpumpe, oder
- eine Stifthubvorrichtung, insbesondere Pin-Lifter, zur Bereitstellung des Objekts in einem Bearbeitungszustand, insbesondere Bearbeitungsposition.

Gemäss einer bestimmten Ausführungsform kann durch die Ansteuerung der als Prozessgasbereitstellungseinheit ausgebildeten Periphereinheit eine definierte Gasmenge für einen Prozesszyklus in dem Vakuumprozessvolumen bereitstellbar sein und damit der definierte Prozesszustand zumindest teilweise bereitstellbar sein.

Die Erfindung betrifft ausserdem eine Regel- und Steuerungseinheit für ein Vakuumprozesssystem, wobei das Vakuumprozesssystem zumindest ein Vakuumventil aufweist, das zur Regelung eines Volumen- oder Massenstroms und/oder zum gasdichten Abschluss eines Prozessvolumens (1) ausgebildet ist und einen mittels einer Antriebseinheit verstellbaren Ventilverschluss aufweist, und zudem über ein evakuierbares Vakuumprozessvolumen, in welches das Objekt zu dessen Bearbeitung einbringbar ist, und eine zur zumindest teilweisen Bereitstellung eines definierten Prozesszustandes in dem Vakuumprozessvolumen ausgebildete Periphereinheit verfügt. Das Vakuumventil, die Periphereinheit und das Vakuumvolumen können gemäss hierin beschriebener Ausführungen ausgebildet sein.

Die Regel- und Steuerungseinheit ist zur mehrfachen Ausführung eines Prozesszyklus ausgebildet und konfiguriert. Der Prozesszyklus umfasst eine derartige Ansteuerung der Periphereinheit, dass zumindest ein Teil des definierten Prozesszustands bereitstellbar ist, und eine Ausführung eines eine gezielte Variation bzw. Einstellung des Ventilöffnungszustands bereitstellenden Regelzyklus durch Ansteuerung der Antriebseinheit basierend auf einer aktuell bestimmten Regelgrösse für einen Prozessparameter und basierend auf einer Zielgrösse, insbesondere wodurch die Regelgrösse an die Zielgrösse durch eine so bewirkte Zustandsänderung des Ventilverschlusses annäherbar ist. Die Ansteuerung der Periphereinheit und die Ausführung des Regelzyklus sind im Rahmen des Prozesszyklus mit einer bestimmten zeitlichen Relation durchführbar.

Die Regel- und Steuerungseinheit kann in kabelgebundener oder kabelloser Kommunikationsverbindung mit den weiteren steuerbaren Komponenten des Systems stehen.

Die Regel- und Steuerungseinheit kann ferner eine (logische und/oder physische) Schnittstelle zur Anpassung oder Aktualisierung derer Software oder Algorithmen und/oder zum Auslesen von Protokolldaten aufweisen.

Die Erfindung betrifft ferner ein Verfahren zur Durchführung eines Prozesszyklus mit einem Vakuumprozesssystem, wobei das Vakuumprozesssystem zumindest aufweist
- ein Vakuumventil, das zur Regelung eines Volumen- oder Massenstroms und/oder zum gasdichten Abschluss eines Prozessvolumens ausgebildet ist und einen mittels einer Antriebseinheit verstellbaren Ventilverschluss aufweist,
- ein evakuierbares Vakuumprozessvolumen, in welches das Objekt zu dessen Bearbeitung einbringbar ist, und
- eine zur zumindest teilweisen Bereitstellung eines definierten Prozesszustandes in dem Vakuumprozessvolumen ausgebildete Periphereinheit.

Im Rahmen des Verfahrens wird ein Prozesszyklus, insbesondere mehrfach, ausgeführt. Der Prozesszyklus umfasst zumindest
- ein derartiges Ansteuern der Periphereinheit, dass zumindest ein Teil des definierten Prozesszustands bereitgestellt wird, und
- ein Ausführen eines eine gezielte Variation bzw. Einstellung des Ventilöffnungszustands bereitstellenden Regelzyklus durch Ansteuern der Antriebseinheit basierend auf einer aktuell bestimmten Regelgrösse für einen Prozessparameter und basierend auf einer Zielgrösse, insbesondere wodurch die Regelgrösse an die Zielgrösse durch eine so bewirkte Zustandsänderung des Ventilverschlusses annäherbar ist.

Das Ansteuern der Periphereinheit und das Ausführen des Regelzyklus werden im Rahmen des Prozesszyklus mit einer definierten zeitlichen Relation durchgeführt.

Die Erfindung betrifft zudem ein Computerprogrammprodukt, das auf einem maschinenlesbaren Träger gespeichert ist, insbesondere in einer oben beschriebenen Regel- und Steuerungseinheit, mit Programmcode zur zeitlich abgestimmten Durchführung bzw. Steuerung zumindest der folgenden Schritte des obigen Verfahrens:
- ein Ansteuern der Periphereinheit und
- ein Ausführen des Regelzyklus mit einem geregelten Variieren bzw. Einstellen des Ventilöffnungszustands,

Insbesondere wird das Programm bzw. der Programmcode in einer elektronischen Datenverarbeitungseinheit, insbesondere der Regel- und Steuerungseinheit, des Vakuumprozesssystem oder in der Regel- und Steuerungseinheit ausgeführt. Es kann also ein Steuern und Regeln eines (gesamten) Prozesszyklus durch Ausführung eines entsprechenden (computerimplementierten) Algorithmus erfolgen.

Die erfindungsgemässe Vorrichtung und das erfindungsgemässe Verfahren werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Fig. 1: eine schematische Darstellung einer ersten Ausführungsform eines Vakuumprozesssystems zum erfindungsgemässen gesteuert-geregelten Betrieb eines Prozesszyklus;
- Fig. 2: eine weitere Ausführungsform für ein erfindungsgemässes Vakuumbearbeitungssystem; und
- Fig. 3a-c: eine Ausführungsform eines erfindungsgemäss regelbaren Vakuumventils als Pendelventil.

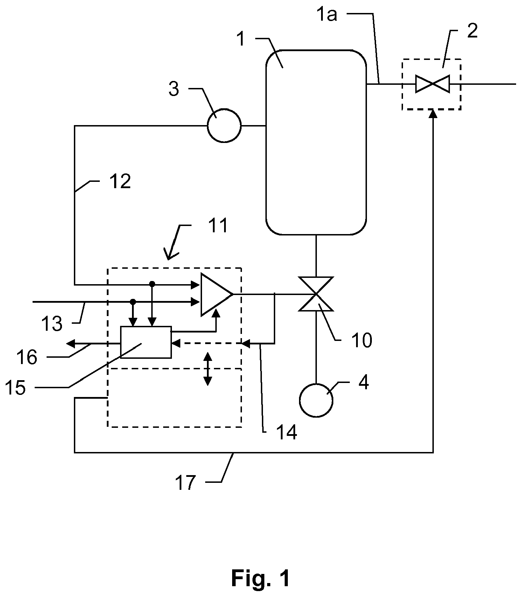

Figur 1 zeigt schematisch einen Aufbau eines erfindungsgemässen Systems zur Bearbeitung eines Objekts, z.B. eines Halbleiterwafers, unter Vakuumbedingungen. Der Aufbau weist eine Vakuumprozesskammer 1 und eine Zuleitung 1a in die Prozesskammer 1 auf, wobei die Zuleitung 1a mit einer Periphereinheit 2, hier einem Gasdurchflussmesser bzw. -regler, gekoppelt ist und damit eine Gasmenge, die in die Prozesskammer 1 strömt, gemessen oder die einströmende Gasmenge entsprechend geregelt werden kann. Ferner ist ein Drucksensor 3 vorgesehen, welcher eine Bestimmung des Drucks im Inneren des Prozessvolumens 1 (Kammerdruck) erlaubt.

An einer Auslassseite der Prozesskammer 1 ist eine Vakuumpumpe 4 mit der Kammer 1 zu deren Evakuierung verbunden. Zwischen der Vakuumpumpe 4 und der Kammer 1 ist ein einstellbares Vakuumventil 10 zur Steuerung bzw. Regelung des abfliessenden Massenstroms angeordnet. Die (gesteuerte) Einstellbarkeit kann hierbei z.B. mittels eines motorisierten, pneumatischen oder hydraulischen Antriebs des Ventils realisiert sein.

Das System weist erfindungsgemäss eine Regel- und Steuerungseinheit 11 auf, die einerseits mit der Periphereinheit 2 verbunden ist und eine direkte Ansteuerung und Einstellung dieser Einheit ermöglicht und andererseits mit dem Ventil 10 verbunden ist und zumindest eine geregelte Ansteuerung des Ventils 10 anhand einer entsprechenden Inputgrösse 12 (Regelgrösse) und einer Sollgrösse 13 (Zielgrösse) bereitstellt. Für die Bereitstellung der Inputgrösse 12 kann seitens der Regel- und Steuerungseinheit 11 ein Signal des Drucksensors 2 erhalten werden. Der Kammerdruck kann hierbei also als relevanter und zu regelnder Prozessparameter dienen.

Die Regel- und Steuerungseinheit 11 vermag damit die zur Ausführung einer Objektbearbeitung vorgesehenen Hauptkomponenten des Systems, das Vakuumventil 11 und den Gaseinlass 2, gemeinsam zu steuern bzw. zu regeln. Ein Vorteil dieser Anordnung liegt darin, dass im Stand der Technik typischerweise gegebene Verzögerungen zwischen einem Gaseinlass, einer Druckmessung und einer Regelung des Kammerdrucks signifikant verringert oder gänzlich vermieden werden können. Diese Verzögerungen beruhten bislang darauf, dass nicht die Steuerung bzw. Regelung des Ventils aktiv das Peripheriegerät 2 ansteuerte, sondern der Regler des Ventils typischerweise ein Startsignal für den Prozessstart oder Gaseinlass erhalten hat und dadurch eine naturgemäss gegebene Verzögerung für die Druckregelung entstanden ist. Aufgrund der immer weiter verringerten Prozesszeiten für einzelne Bearbeitungsschritte (teilweise im Millisekundenbereich) führt eine mit der vorliegenden Erfindung verbundene Verbesserung hinsichtlich der Dauer für die Einstellung der geforderten Prozessbedingungen (Kammerdruck, Temperatur, Plasmazündung etc.) zu einer deutlichen Verbesserung der Gesamtbearbeitungszeit. Der Durchsatz von zu bearbeitenden Objekten kann entsprechend gesteigert werden.

Ein mit dem System ausführbarer Prozesszyklus kann durch die Regel- und Steuerungseinheit 11 eingeleitet werden, indem diese Einheit 11 ein Signal 17 an die Periphereinheit 2 sendet. Das Signal 17 kann hierbei z.B. in Form eines Startsignals für eine vordefiniert ablaufende Aktion (z.B. Variation der einströmenden Gasmenge) der Periphereinheit 2 oder in Form einer fortlaufend übermittelten Steuergrösse zur ebenso fortlaufenden gezielten Ansteuerung der Periphereinheit 2 sein. In anderen Worten kann entweder allein ein Startsignal ausgegeben werden und die Funktion der Periphereinheit 2 dann selbsttätig, vordefiniert ablaufen oder der Zustand der Periphereinheit 2 (z.B. die einströmende Gasmenge) wird aktiv durch die Regel- und Steuerungseinheit 11 über einen bestimmten Zeitraum hinweg eingestellt.

Mittels der Regel- und Steuerungseinheit 11 ist damit ein vorgegebener Prozesszyklus initiierbar. Eine vorbestimmte Menge eines Prozessgases kann in die Kammer 1 gelassen bzw. ein vordefinierter Massen- oder Volumenstrom durch die Kammer kann eingeleitet werden.

Durch die Regel- und Steuerungseinheit 11 kann in Abhängigkeit des Zeitpunktes des Zyklusstarts oder der Steuerung der Periphereinheit 2 ebenso die Regelung der Ventilstellung eingeleitet werden. Die Regel- und Steuerungseinheit 11 erhält hierzu ein aktuelles Drucksignal 12 des Drucksensors 3. Die Regelung kann mit einem definierten zeitlichen Offset gestartet werden.

Durch die Kenntnis des Zeitpunkts, zu welchem der Prozess durch Ansteuerung der Periphereinheit 2 beginnt, kann z.B. zunächst ein gesteuerter Vorregelschritt am Ventil 10 - auch ohne Erhalt des Drucksignals 12 - zeitlich abgestimmt ausgeführt werden. Z.B. wird der Ventilverschluss gezielt in eine Vorregelposition versetzt, die bekanntermassen nahe der zu erwartenden Anfangsregelposition entspricht. Im Anschluss an diesen gesteuerten Versatz kann dann auf ein Regeln anhand des Drucksignals 12 übergegangen (umgeschaltet) werden.

Eine Geschwindigkeitssteigerung resultiert auch aus den naturgemäss gegebenen Signalverzögerungen (Delay) für ein reines Regelsystem des Stands der Technik. Z.B. benötigt der Drucksensor 3 eine gewisse Zeit bis zum Feststellen eines aktuellen Kammerdrucks und für eine entsprechende Signalerzeugung und Ausgabe. D.h. das Regelsystem empfängt die benötigte Regelgrösse ebenfalls mit dieser Verzögerung, woraus sich eine ebensolche Verzögerung für die Regelung und das Erreichen des gewünschten Solldrucks ergibt. Durch das Vorsteuern des Ventils kann diese Signalverzögerung überbrückt werden.

Mittels der Vorsteuerung kann eine erste Verstellstrecke für den Ventilverschluss ohne ein Feedbacksignal (aktueller Druck) gefahren werden und dann in einen Regelschritt, also ein geregeltes Bewegen des Ventilverschlusses, übergegangen werden. Hierdurch lässt sich oben beschriebene Verzögerung reduzieren oder vermeiden, da das Signal des Drucksensors z.B. bereits mit Beginn der späteren Regelphase vorliegt und von dem Regler dann direkt verarbeitet werden kann.

Das Umschalten zwischen den beiden Schritten kann nach einer vordefinierten und aus dem bekannten Ansteuerungsverhalten der Periphereinheit 2 oder des Ventils 10 erfolgen. Da das Umschalten hier automatisch nach Ablauf einer vorgesehene Zeit erfolgt, ist hierzu kein weiteres Feedbacksignal erforderlich.

In einem solchen Ausführungsbeispiel weist der Prozesszyklus im Prinzip drei nacheinander ablaufende Stufen, wir folgt, auf.
a) In einer ersten Stufe - dem aktiven Ansteuern des Periphergeräts 2 - wird der Gaseinlass gesteuert.
b) In einer zweiten Stufe - einem Vorregelschritt - wird der Ventilverschluss anhand einer vorbekannten Zwischensollposition (Vorregelposition) in diese Position gestellt. Der Vorregelschritt wird durch das Startsignal 17 ausgelöst bzw. getriggert. Das Startsignal 17 wird von der Regel- und Steuerungseinheit 11 erzeugt.
c) Ein Übergang von dem Vorregelschritt in einen Regelschritt, welcher die dritte Stufe des Prozesszyklus bildet, erfolgt bei Erreichen der Vorregelposition oder mit einem bekannten zeitlichen Unterschied zum Startsignal automatisch. Das Erreichen der Vorregelposition kann z.B. durch eine aktuell und fortlaufend festgestellte Verschlussposition und ein Vergleichen dieser Position mit der vorgegebenen Vorregelposition erkannt werden. Eine entsprechend aktuelle Verschlusspositionsinformation 14 kann von dem Ventil 10 bzw. einem Ventilantrieb an die Regel- und Steuerungseinheit 11 übertragen werden. Insbesondere erfolgt eine solche Informationsübertragung zu einem Regel- und Optimierungsmodul 15 der Regel- und Steuerungseinheit 11 (angezeigt durch die gestrichelte Verlängerung des logischen Pfeils 14). Sobald die Vorregelposition erreicht wird, erfolgt ein Umschalten von dem Vorregelbetrieb (Steuerung) in den echten Regelbetrieb (Regelschritt).

Es versteht sich, dass alternativ - jedoch ebenfalls in zeitlicher Abstimmung - z.B. die zweite Stufe des Prozesses bereits vor der ersten Stufe des Prozesses erfolgen kann. Ferner kann in einer alternativen Ausführungsform der Prozesszyklus zweistufig erfolgen, wobei die Vorsteuerung des Ventils 10 entfallen kann.

In dem durch die Regel- und Steuerungseinheit 11 bereitgestellten Regelschritt wird fortlaufend als Inputgrösse 12, d.h. als aktuell bestimmte Regelgrösse, ein aktuelles Drucksignal 12 des Drucksensors 3 erhalten, womit ein aktueller Druckzustand in der Prozesskammer 1 bekannt bzw. bereitgestellt ist. Der Steuer- und Regeleinheit 11 wird zudem als Soll- oder Zielgrösse 13 ein Solldruck oder ein Solldruckverlauf für einen jeweiligen Bearbeitungsprozess bereitgestellt. Anhand dieser Eingangsgrössen wird mit der Steuer- und Regeleinheit 11 ein Stellsignal erzeugt und an das motorisierte Ventil 10 ausgegeben.

Zur Einstellung eines gewünschten Innendrucks in der Prozesskammer 1 wird im Rahmen des Regelzyklus also die Ventilöffnung des Vakuumventils 10 so variiert, dass ein Gasabfluss aus der Prozesskammer so erfolgt, dass der aktuelle Innendruck an einen Zieldruck angenähert werden kann - in einem ersten Schritt mittels einem gesteuerten, einmaligen Verstellen des Ventilverschlusses in die Vorregelposition und in einem zweiten Schritt mittels einem geregelten Variieren der Verschlussstellung anhand der fortlaufend erfassten Regelgrösse. Hierbei ist insbesondere ein durch eine definierte Positionsänderung des Ventilverschlusses bewirkter Effekt auf die Regelgrösse im Wesentlichen prognostizierbar, wodurch eine gezielte und effiziente Regelung bereitgestellt werden kann.

Beispielsweise soll in einem ersten Zeitabschnitt eines Bearbeitungsprozesses die Ventilöffnung verhältnismässig weit geöffnet eingestellt werden, damit eine möglichst schnelle Absenkung des Innendrucks erfolgt und im weiteren Verlauf der Regelung die Ventilöffnung weniger weit geöffnet eingestellt werden, damit in einen späteren Zeitabschnitt der gewünschte Innendruck durch ein kontrolliertes Abfliessen einer kleineren Gasmenge pro Zeiteinheit eingestellt und gehalten werden kann, wobei insbesondere eine laminare oder molekulare Gasströmung oder aber auch eine Mischform aus beidem vorliegt. Für beide dieser Zeitabschnitte, also für jeden einzustellenden Solldruck, kann ein Regelzyklus mit unterschiedlich angepassten Parametern hinterlegt sein.

Durch das Variieren der Ventilposition, d.h. der Position des Ventilverschlusses relativ zur Ventilöffnung, wird der Druck im Inneren der Prozesskammer 1 variiert und damit für jeden Regelzyklus ein Regelungsverlauf, insbesondere eine Regelkurve, definiert, also Drücke und/oder Ventilpositionen zu jeweiligen Zeitpunkten in einem bestimmten Zeitintervall. Ein Bearbeitungsprozess in einer Prozesskammer wird typischerweise vielfach wiederholt in Prozesszyklen (mehrfache Ausführung auch des Regelungsverlaufs bzw. Regelzyklus) ausgeführt, wobei die Druckregelung dann jeweils entsprechend zyklisch gleichartig ausgeführt werden soll.

Mittels der Regel- und Steuerungseinheit 11 kann zudem beispielsweise eine Bestückung der Prozesskammer mit einem zu bearbeitenden Werkstück, z.B. Halbleiter-Wafer, und im Anschluss die Schaffung einer definierten Atmosphäre oder die Zündung eines Plasmas in der Prozesskammer gesteuert werden. Für eine solche Prozessatmosphäre wird typischerweise ein definiertes Prozessgas in die Prozesskammer 10 geleitet - insbesondere via den Gasdurchflussmesser bzw. -regler 2 - und anhand der Vakuumabsaugung und deren Regelung mit dem Ventil 10 der Innendruck in der Prozesskammer auf ein vordefiniertes und Niveau gebracht.

Erfindungsgemäss kann die Regel- und Steuerungseinheit 11 zudem eine Aktualisierungsfunktionalität aufweisen. Die Aktualisierungsfunktionalität kann während des Durchlaufens des Regelzyklus oder zumindest während des Regelschrittes ausgeführt werden. Hierbei wird die empfangene Regelgrösse 12 (z.B. Signal des Drucksensors) zumindest zeitweise erfasst und basierend darauf ein Istregelverlauf abgeleitet. Es werden also beispielsweise ein Druckverlauf und/oder - bei Erhalt der Verschlusspositionsinformation 17 als Teil der Regelgrösse - ein Verschlusspositionsverlauf abgeleitet, d.h. Werte für den Kammerinnendruck und Werte für die Verschlussposition in Bezug zu Regelzeitpunkten.

Im Rahmen einer Aktualisierung des Regelzyklus mittels der Aktualisierungsfunktionalität kann der aufgenommene Istregelverlauf mit einem Referenzregelverlauf verglichen werden und auf dieser Basis eine Regelabweichung abgeleitet werden. Der Referenzregelverlauf kann dabei einen vorab erfassten und ggf. gezielt und unter definierten und kontrollierten Bedingungen ausgeführten Regelzyklus oder - schritt repräsentieren. Beispielsweise ist der Referenzregelverlauf in Form einer Sollregelkurve hinterlegt.

In Abhängigkeit einer Ausprägung der abgeleiteten Regelabweichung und basierend auf dem im Wesentlichen prognostizierbaren Effekt auf die Regelgrösse 12 kann dann eine Anpassung z.B. der Vorregelposition oder eine Anpassung der Ansteuerung der Periphereinheit 2 vorgenommen werden. In anderen Worten kann z.B. der Gaseinlass derart neu eingestellt werden, dass der Istregelverlauf im Rahmen der berechneten Abweichung an den Referenzverlauf angenähert wird.

Die Regel- und Steuerungseinheit 11 ist derart konfigurierbar, dass die Aktualisierungsfunktionalität fortlaufend, insbesondere über eine Vielzahl von Regelzyklen während eines Produktionsprozesses, ausgeführt wird.

Das mit Figur 1 gezeigte System ermöglicht also zum einen ein schnelles Einregeln eines gewünschten Druckzustandes in der Prozesskammer 1 (durch die mindestens Zweistufigkeit des gesamthaft kontrollierten Prozesszyklus) und darüber hinaus eine fortlaufende Anpassung des Regelverlaufs und/oder der Ansteuerung einer weiteren Prozesseinheit 2 (Periphereinheit) derart, dass z.B. bei allfällig auftretenden Abweichungen von einer gewünschten Regelung automatisch eine Korrektur des Prozesszyklus durch z.B. Nachstellen von Regelparametern (z.B. Vorregelposition) oder Anpassen der aktiven Ansteuerung der weiteren Prozesseinheit 2 erfolgen kann.

Zur Verifizierung der Prozessintegrität und/oder -qualität kann zudem eine Überprüfungs- bzw. Überwachungsfunktionalität vorgesehen sein.

Anhand der Information über den Referenzverlauf der Regelung kann nun ein aktuell erfasster Regelungsverlauf mit dem Sollverlauf verglichen werden und basierend auf diesem Vergleich eine Information abgeleitet werden, ob die Regelung in gesetzten Grenzen, z.B. innerhalb eines Toleranzbereichs, durchgeführt worden ist oder nicht.

Die Regel- und Steuerungseinheit 11 kann ferner eine Lernfunktion aufweisen, mittels derer die Information bezüglich einer Ansteuerung der Periphereinheit 2 oder einer Referenzregelung erstellt werden kann. Hierzu wird ein Produktionszyklus mehrere Male mit gesetzten Sollbedingungen (z.B. Solldruck, Solltemperatur, Druckverlauf, Temperaturverlauf etc) ausgeführt und mit der Regel- und Steuerungseinheit 11 der Druck in der Kammer 1 über den Gaseinlass 2 und die Ventilstellung zur Erreichung des Solldrucks geregelt eingestellt. Während des Durchfahrens dieser Produktionszyklen werden die Zustände des Gaseinlasses 2 und insbesondere auch die Ventilstellungen in den einzelnen Zyklen über die Prozesszeit gespeichert. Aus der so erzeugbaren Datenmenge wird dann, z.B. mittels Ausgleichsrechung oder Modellierung, eine die einzelnen Datensätze (ein Datensatz je Prozesszyklus) vereinende Sollprozessinformation abgeleitet.

Die Regel- und Steuerungseinheit 11 verfügt zudem über einen Ausgabekanal 16. Hiermit kann ein Signal ausgegeben werden, das eine Information über den aktuellen Prozesszustand aufweist. So kann ein Benutzer beispielsweise erkennen, ob der Prozess in dessen vorgegebenen Grenzen abläuft oder Abweichungen hiervon vorliegen. Alternativ oder ergänzend kann das Signal einer Recheneinheit oder übergeordneten Prozesssteuerung bereitgestellt werden, wodurch z.B. automatische Anpassungen eines Gesamtprozesses vorgenommen werden können. Beispielsweise kann eine einzulassende Gasmenge oder Kammertemperatur gesteuert durch die Regel- und Steuerungseinheit 11 variiert werden.

Durch eine solche Überprüfungsfunktionalität lässt sich somit prüfen, ob die für einen Prozess definierten Randbedingungen eingehalten werden. Wird z.B. eine Abweichung zwischen einer aktuelle aufgenommenen Regelkurve und der für den Prozess hinterlegten Sollregelkurve festgestellt, so kann anhand dieser Abweichung beispielsweise auf das Vorliegen eines Lecks in der Prozesskammer oder auf eine abweichende Gaseinleitung geschlossen werden.

Es versteht sich, dass die Periphereinheit 2 beispielsweise als Verdampfungssystem ausgebildet ist, womit eine gewünschte Prozessgasmenge erzeugt und in die Kammer eingelassen bzw. eingeblasen werden kann. Die Gasapplikation kann z.B. gepulst erfolgen, d.h. für jeden Prozessschritt ein Puls oder schrittweise gepulste Zunahme der Gasmenge für einen einzelnen Prozessschritt.

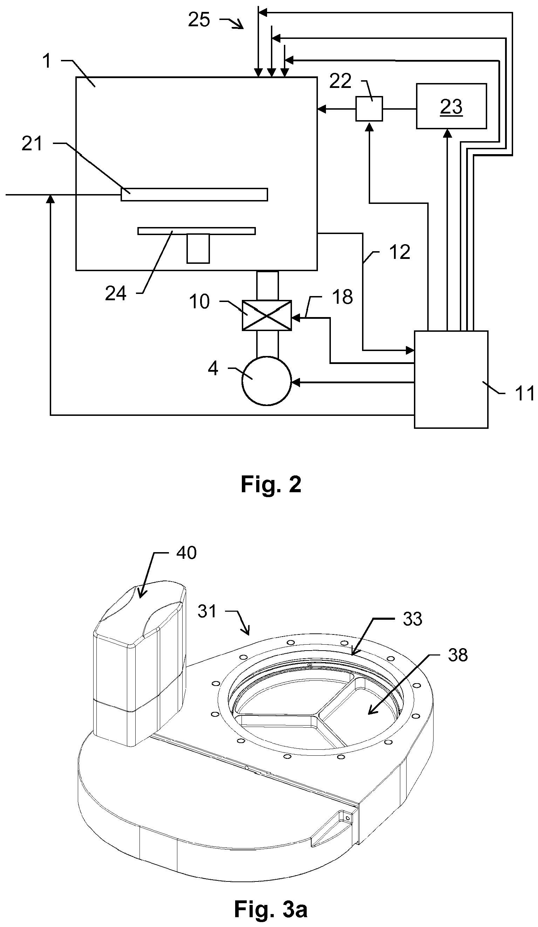

Die Figur 2 zeigt eine weitere Ausführungsform für ein erfindungsgemässes Vakuumbearbeitungssystem. Hierzu ist wiederum eine Prozesskammer 1 mit einer Vakuumpumpe 4 verbunden, wobei mittels eines Vakuumregelventils 10 der durch die Pumpe 4 bereitstellbaren Volumenstrom aus der Kammer 1 einstellbar und/oder regelbar ist. Ein Drucksignal 12 stellt eine Information bezüglich des Atmosphärenzustands in der Kammer 1 bereit.

Eine Regel- und Steuerungseinheit 11 ist derart ausgebildet, dass der Innendruck in der Kammer 1 anhand der Druckinformation 12 und mittels der Einstellbarkeit eines Öffnungsquerschnitts des Ventils 10 geregelt werden kann. Das Ventil 10 erhält hierfür entsprechende Steuersignale 18 von der Regel- und Steuerungseinheit 11. eine Ein Istzustand in der Kammer 1 (hier: Istdruck) wird durch die Regelung (hier: gezielter Gasabstrom aus der Kammer 1) an einen Sollzustand (hier: vorgegebener Solldruck) angenähert.

Das System verfügt über weitere Komponenten, die für eine gezielte Bearbeitung eines Objekts (z.B. Halbleiterwafer) vorgesehen sind. Diese Periphereinheiten werden verkörpert durch eine Elektrodenanordnung 21 zur Erzeugung eines Plasmas in der Prozesskammer 1, durch eine Vergasungs- und/oder Gaseinspritzvorrichtung 22 zur Bereitstellung eines Prozessgases oder Precursorgases (kann sowohl gepulst oder nach Bedarf betrieben werden) via eine erste Gaszuleitung, durch einen Flüssigkeits- und/oder Precursortank 23, durch eine temperierbare und/oder verstellbare Aufnahme 24 für das Objekt sowie durch weitere steuerbare Gaszuleitungen 25.

Die Regel- und Steuerungseinheit 11 ist mit jeder dieser Periphereinheiten 21-25 verbunden. Die Regel- und Steuerungseinheit 11 ist zudem dazu ausgebildet, jede dieser Einheiten 21-25 gemäss einem vorgegeben Prozesszyklus gezielt anzusteuern und den Bearbeitungsprozess damit nach einem (festgelegten) Rezept ablaufen zu lassen. Durch diese gebündelte Ansteuerung und Regelung des Prozesszyklus kann eine vorteilhafte Prozessgeschwindigkeit erreicht werden. Da die Hauptschritte des Prozesses sämtlich auf einer gemeinsamen Basis kontrolliert und ausgeführt werden, kann eine Optimierung bezüglich potentieller Verzögerungen zwischen Einzelschritten realisiert werden.

Insbesondere kann die Durchführung einzelner Subprozesse, wie etwa Befüllen der Kammer mit einem definierten Prozessgas (mittels der Gaszufuhreinheiten 22,23), Einstellen eines definierten Prozessdrucks (mittels der Ventilregelung) und Erzeugen eines Plasmas (durch die Elektroden 21) bei einem bestimmten Druck zeitlich koordiniert und abgestimmt erfolgen. Hierdurch lässt sich eine Verkürzung der Bearbeitungszeit verglichen mit derartigen Prozessen des Standes der Technik erzielen.

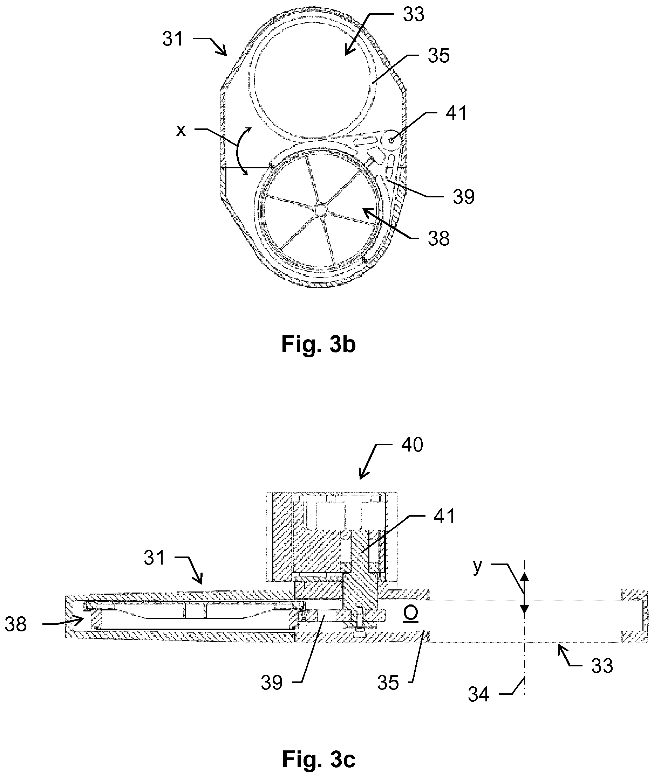

Mit den Figuren 3a bis 3c ist eine mögliche Ausführungsform eines Vakuumventils in Form eines Pendelventils als Teil eines erfindungsgemässen Bearbeitungssystems dargestellt. Das Ventil zum im Wesentlichen gasdichten Unterbrechen eines Fliesswegs besitzt ein Ventilgehäuse 31, welches eine Öffnung 33 aufweist. Die Öffnung hat einen kreisrunden Querschnitt. In einer Geschlossenstellung des Ventiltellers 38 (Ventilverschluss), ist die Öffnung 33 mittels des Ventiltellers 38 gasdicht verschlossen. Eine Offenstellung O des Ventiltellers 38 ist in den Figuren 3b und 3c veranschaulicht.

Die Öffnung 33 wird von einem Ventilsitz umschlossen. Dieser Ventilsitz wird von einer axial in Richtung des Ventiltellers 38 weisenden und quer zur Öffnungsachse 34 verlaufenden, die Form eines Kreisrings aufweisenden Dichtfläche 35, welche im Ventilgehäuse 31 ausgeformt ist, gebildet.

Ausserdem besitzt das Ventil einen schwenkbaren und zudem im Wesentlichen parallel zur Öffnungsachse 34 verstellbaren Ventilteller 38.

Der Ventilteller 38 ist über einen seitlich an dem Teller angeordneten, sich senkrecht zur Öffnungsachse 34 erstreckenden Arm 39 mit einem elektrischen Antrieb 40 (Motor) verbunden. Dieser Arm 39 befindet sich in der Geschlossenstellung des Ventiltellers 38 ausserhalb des entlang der Öffnungsachse 34 geometrisch projizierten Öffnungsquerschnitts der Öffnung 33.

Ein elektrischer Antrieb 40 ist durch Einsatz eines entsprechenden Getriebes derart ausgebildet, dass der Ventilteller 38 - wie bei einem Pendelventil üblich - mittels einer Querbewegung x des Antriebs 40 quer zur Öffnungsachse 34 und im Wesentlichen parallel über den Querschnitt der Öffnung 33 und senkrecht zur Öffnungsachse 34 in Form einer Schwenkbewegung um eine Schwenkachse 41 zwischen einer Offenstellung O und einer Zwischenstellung schwenkbar und mittels einer parallel zur Öffnungsachse 34 erfolgenden Längsbewegung y des Antriebs 40 linear verschiebbar ist. In der Offenstellung O, ist der Ventilteller 38 in einem seitlich neben der ersten Öffnung 33 angeordneten Verweilabschnitt positioniert, so dass die Öffnung 33 und der Fliessweg freigegeben sind. In der Zwischenstellung ist der Ventilteller 38 über der ersten Öffnung 33 beabstandet positioniert und überdeckt den Öffnungsquerschnitt der Öffnung 33. In der Geschlossenstellung ist die Öffnung 33 gasdicht geschlossen und der Fliessweg unterbrochen, indem ein gasdichter Kontakt zwischen dem Ventilverschluss 38 (Ventilteller) und der Dichtfläche 35 des Ventilsitz besteht.

Um ein automatisiertes und geregeltes Öffnen und Schliessen des Ventils zu ermöglichen, sieht das Ventil eine elektronische Regel- und Steuerungseinheit vor, die derart ausgebildet ist und mit dem Antrieb 40 in derartiger Verbindung steht, dass der Ventilteller 38 zum gasdichten Abschliessen eines Prozessvolumens oder zum Regeln eines Innendrucks dieses Volumens entsprechend verstellbar ist. Eine solche Regel- und Steuerungseinheit bildet zusammen mit dem Ventil, einem Prozessvolumen und einer Periphereinheit ein Ventilsystem gemäss der Erfindung.

Die Stellung des Ventiltellers 38 wird anhand einer Regelgrössen und eines ausgegebenen Steuersignals variabel eingestellt. Als Inputsignal wird eine Information z.B. über einen aktuellen Druckzustand in dem mit dem Ventil verbundenen Prozessvolumen erhalten. Zudem kann dem Regler eine weitere Inputgrösse, z.B. ein Massenzustrom in das Volumen, bereitgestellt werden. Anhand dieser Grössen und anhand eines vorgegebenen Solldrucks, der für das Volumen eingestellt bzw. erreicht werden soll, erfolgt dann eine geregelte Einstellung des Ventils über die Zeit eines Regelzyklus, so dass ein Massenabfluss aus dem Volumen mittels des Ventils über die Zeit geregelt werden kann. Hierzu ist hinter dem Ventil typischerweise eine Vakuumpumpe vorgesehen, d.h. das Ventil ist zwischen der Prozesskammer und der Pumpe angeordnet. Somit kann ein gewünschter Druckverlauf eingeregelt werden.

Durch die Einstellung des Ventilverschlusses 38 wird ein jeweiliger Öffnungsquerschnitt für die Ventilöffnung 33 eingestellt und damit die mögliche Gasmenge eingestellt, die pro Zeiteinheit aus dem Prozessvolumen evakuiert werden kann. Der Ventilverschluss 38 kann zu diesem Zweck eine von einer kreisrunden Form abweichende Form aufweisen, insbesondere um einen möglichst laminaren Medienfluss zu erreichen.

Zur Einstellung des Öffnungsquerschnitts ist der Ventilteller 38 durch die Regel- und Steuerungseinheit mittels der Querbewegung x des Antriebs 40 von der Offenstellung O in die Zwischenstellung und mittels der Längsbewegung y des Antriebs 40 von der Zwischenstellung in die Geschlossenstellung verstellbar. Zum vollständigen Öffnen des Fliesswegs ist der Ventilteller 38 durch die Steuerung mittels der Längsbewegung y des Antriebs 40 von der Geschlossenstellung in der Zwischenstellung und von dort aus mittels der Querbewegung x des Antriebs 40 von der Zwischenstellung in die Offenstellung O verstellbar.

Im vorliegenden Ausführungsbeispiel ist der Antrieb 40 als ein Elektromotor ausgebildet, wobei das Getriebe derart umschaltbar ist, dass ein Antreiben des Antriebs 40 entweder die Querbewegung x oder die Längsbewegung y bewirkt. Der Antrieb 40 und das Getriebe werden von der Regelung elektronisch angesteuert. Derartige Getriebe, insbesondere mit Kulissenschaltungen, sind aus dem Stand der Technik bekannt. Weiters ist es möglich, mehrere Antriebe zum Bewirken der Querbewegung x und der Längsbewegung y einzusetzen, wobei die Steuerung die Ansteuerung der Antriebe übernimmt.

Das präzise Regeln bzw. Einstellen des Durchflusses mit dem beschriebene Pendelventil ist nicht nur durch das schwenkende Verstellen des Ventiltellers 38 zwischen der Offenstellung O und der Zwischenstellung mittels der Querbewegung x, sondern vor allem durch lineares Verstellen des Ventiltellers 38 entlang der Öffnungsachse 34 zwischen der Zwischenstellung, der Geschlossenstellung mittels der Längsbewegung y möglich. Das beschriebene Pendelventil kann für präzise Regelaufgaben eingesetzt werden.

Sowohl der Ventilteller 38 als auch der Ventilsitz besitzen jeweils eine Dichtfläche 35 - eine erste und eine zweite Dichtfläche. Die erste Dichtfläche 35 weist zudem eine Dichtung auf. Diese Dichtung kann beispielsweise als Polymer mittels Vulkanisation auf den Ventilsitz aufvulkanisiert sein. Alternativ kann die Dichtung z.B. als O-Ring in einer Nut des Ventilsitzes ausgeführt sein. Auch kann ein Dichtmaterial auf den Ventilsitz aufgeklebt sein und dadurch die Dichtung verkörpern. In einer alternativen Ausführungsform kann die Dichtung seitens des Ventiltellers 38, insbesondere auf der zweiten Dichtfläche, angeordnet sein. Auch Kombinationen dieser Ausführungen sind denkbar.

Alternativ zu einem Pendelventil wie dargestellt kann das erfindungsgemässe Vakuumprozesssystem mit einem anderen Vakuumventiltyp, z.B. einem Klappventil, Schieberventil oder einem sog. Butterfly-Regelventil, realisiert sein. Insbesondere ist das System mit Druckregelventilen zum Einsatz im Vakuumbereich ausgebildet. Ferner sind ebenso Pendelventile einsetzbar, deren Verschluss nur in einer Richtung verstellt werden kann.

Die Regel- und Steuerungseinheit kann beispielsweise in integrierter Bauweise mit dem Vakuumventil ausgebildet sein, d.h. die Regel- und Steuerungseinheit wird durch und mit dem Ventil bereitgestellt und die weiteren Periphergeräte, die mit der Regel- und Steuerungseinheit angesteuert werden sollen, sind mit dem Ventil bzw. dessen Regel- und Steuerungseinheit verbunden.

Es versteht sich, dass die dargestellten Figuren nur mögliche Ausführungsbeispiele schematisch darstellen. Die verschiedenen Ansätze können erfindungsgemäss ebenso miteinander sowie mit Verfahren und Vorrichtungen zur Druckregelung oder Steuerung für und von Vakuumprozessen des Stands der Technik kombiniert werden.

## Patentansprüche

1. Vakuumprozesssystem zur definierten Bearbeitung eines Objekts, zumindest aufweisend
• ein evakuierbares Vakuumprozessvolumen (1), in welches das Objekt zu dessen Bearbeitung einbringbar ist,
• ein Vakuumventil (10) zur Regelung eines Volumen- oder Massenstroms aus dem Vakuumprozessvolumen (1) und/oder zum gasdichten Abschluss des Vakuumprozessvolumens (1),
• eine zur zumindest teilweisen Bereitstellung eines definierten Prozesszustandes in dem Vakuumprozessvolumen (1) ausgebildete Periphereinheit (2,4,21-25) und
• eine Regel- und Steuerungseinheit (11),
wobei das Vakuumventil (10) aufweist
• einen Ventilsitz, der eine eine Öffnungsachse (34) definierende Ventilöffnung (33) und eine die Ventilöffnung (33) umlaufende erste Dichtfläche (35) aufweist,
• einen Ventilverschluss (38) zum im Wesentlichen gasdichten Verschliessen der Ventilöffnung (33) mit einer zweiten zu der ersten Dichtfläche (35) korrespondierenden Dichtfläche und
• eine mit dem Ventilverschluss (38) gekoppelte Antriebseinheit (40), die derart ausgebildet ist, dass der Ventilverschluss (38)
□ zur Bereitstellung eines jeweiligen Ventilöffnungszustands definiert variierbar und einstellbar ist und
□ von einer Offenposition (O), in welcher der Ventilverschluss (38) die Ventilöffnung (33) zumindest teilweise freigibt in eine Schliessposition, in welcher die erste Dichtfläche (35) auf die zweite Dichtfläche angedrückt ist und die Ventilöffnung (33) im Wesentlichen gasdicht verschliesst, und zurück verstellbar ist,
**dadurch gekennzeichnet, dass**
die Regel- und Steuerungseinheit (11) zur mehrfachen Ausführung eines Prozesszyklus ausgebildet ist, mit
• einer derartigen Ansteuerung der Periphereinheit (2,4,21-25), dass zumindest ein Teil des definierten Prozesszustands bereitstellbar ist, und
• einer Ausführung eines eine gezielte Variation bzw. Einstellung des Ventilöffnungszustands bereitstellenden Regelzyklus durch Ansteuerung der Antriebseinheit (40) basierend auf einer aktuell bestimmten Regelgrösse (12) für einen Prozessparameter und basierend auf einer Zielgrösse (13), insbesondere wodurch die Regelgrösse (12) an die Zielgrösse (13) durch eine so bewirkte Zustandsänderung des Ventilverschlusses (38) annäherbar ist,
wobei die Ansteuerung der Periphereinheit (2,4,21-25) und die Ausführung des Regelzyklus im Rahmen des Prozesszyklus mit einer bestimmten zeitlichen Relation durchführbar sind.

2. Vakuumprozesssystem nach Anspruch 1,
**dadurch gekennzeichnet, dass**
die Regel- und Steuerungseinheit (11) eine, insbesondere prozesszyklenübergreifende, Aktualisierungsfunktionalität aufweist, die derart ausgestaltet ist, dass bei deren Ausführung
• während eines ersten Prozesszyklus eine Prozessinformation abgeleitet wird und
• ein nachfolgender zweiter Prozesszyklus basierend auf der Prozessinformation angepasst wird.

3. Vakuumprozesssystem nach Anspruch 2,
**dadurch gekennzeichnet, dass**
• durch Erfassen der Regelgrösse (12) bei Ausführung des ersten Prozesszyklus ein Istregelverlauf (21,51) als Prozessinformation abgeleitet wird,
• der Istregelverlauf mit einem hinterlegten Referenzregelverlauf verglichen und eine Regelabweichung abgeleitet wird und
• das Anpassen des zweiten Prozesszyklus basierend auf einer Ausprägung der abgeleiteten Regelabweichung erfolgt.

4. Vakuumprozesssystem nach Anspruch 3,
**dadurch gekennzeichnet, dass**
die Regel- und Steuerungseinheit (11) derart ausgestaltet ist, dass der Referenzregelverlauf durch Erfassen der Regelgrösse (12) während Ausführung einer Mehrzahl von Regelzyklen erzeugbar und hinterlegbar ist, insbesondere wobei eine Mittelung der für ein bestimmtes Zeitintervall oder für einen bestimmten Zeitpunkt des Regelschritts erfassten Regelgrössen erfolgt.

5. Vakuumprozesssystem nach einem der Ansprüche 1 bis 4, **dadurch gekennzeichnet, dass**
• durch Erfassen der Regelgrösse (12) bei Ausführung des ersten Prozesszyklus die Prozessinformation abgeleitet wird und
• basierend auf der Prozessinformation die Ansteuerung der Periphereinheit (2,4,21-25) für den zweiten Prozesszyklus angepasst wird,
insbesondere wobei die angepasste Ansteuerung der Periphereinheit (2,4,21-25) als aktuelle Ansteuerung für den Prozesszyklus bereitgestellt und/oder hinterlegt wird, insbesondere wobei die Anpassung der Ansteuerung der Periphereinheit (2,4,21-25) basierend auf einem zumindest teilweise prognostizierbaren Effekt auf die Regelgrösse (12) erfolgt.

6. Vakuumprozesssystem nach einem der Ansprüche 1 bis 5, **dadurch gekennzeichnet, dass**
die Regel- und Steuerungseinheit (11) eine Lernfunktionalität zur Erzeugung eines Referenzprozessverlaufs aufweist, wobei die Lernfunktionalität derart konfiguriert ist, dass bei deren Ausführung
• für eine Durchführung von einer Anzahl von im Wesentlichen gleichartigen Prozesszyklen entsprechend eines Sollbetriebs für den Prozesszyklus
□ jeweilige Sollpositionen für den Ventilverschluss (38) und/oder
□ jeweilige Steuergrössen zur Ansteuerung der Periphereinheit (2,4,21-25)
über zumindest je einen Zeitabschnitt eines jeweiligen Prozesszyklus erfasst werden und
• die erfassten Sollpositionen und/oder Steuergrössen mit Bezug zu jeweiligen Zeitabschnitten des Prozesszyklus als der Referenzprozessverlauf gespeichert werden.

7. Vakuumprozesssystem nach einem der Ansprüche 1 bis 6, **dadurch gekennzeichnet, dass**
die Regel- und Steuerungseinheit (11)
• zur Ausgabe eines Startsignals (5) für die Ansteuerung der Periphereinheit (2,4,21-25) und
• zur Einleitung des Regelzyklus mit einem definierten Zeitversatz bezüglich des Startsignals
ausgebildet ist.

8. Vakuumprozesssystem nach einem der Ansprüche 1 bis 7, **dadurch gekennzeichnet, dass**
• der Prozessparameter durch eine Druckinformation für das Vakuumprozessvolumen (1) verkörpert ist,
• die Zielgrösse (13) ein im Vakuumprozessvolumen (1) zu erreichender Solldruck ist und
• die aktuell bestimmte Regelgrösse (12) einen aktuellen Druck im Vakuumprozessvolumen (1) repräsentiert.

9. Vakuumprozesssystem nach einem der Ansprüche 1 bis 8, **dadurch gekennzeichnet, dass**
• die Zielgrösse (13) ein im Vakuumprozessvolumen (1) zu erreichender Solldruck ist und
• die aktuell bestimmte Regelgrösse (12) einen aktuellen Medienzufluss in das Prozessvolumen (1) angibt, insbesondere wobei die aktuell bestimmte Regelgrösse eine aktuelle Druckeinlassgrösse berücksichtigt.

10. Vakuumprozesssystem nach einem der Ansprüche 1 bis 9, **dadurch gekennzeichnet, dass**
die Periphereinheit (2,4,21-25) ausgebildet ist als
• Prozessgasbereitstellungseinheit (2,22,23,25), insbesondere als Verdampfer, als Gaseinlassventil oder als Massendurchflussregler,
• Plasmaerzeuger (21), insbesondere hochfrequent umpolbare Elektroden, insbesondere mit einer Frequenz von mindestens 13 MHz,
• Vakuumtransferventil zur Be- und/oder Entladung des Vakuumprozessvolumens,
• Temperiereinheit (24) zu Einstellung einer definierten Temperatur in dem Vakuumprozessvolumen oder an dem Objekt,
• Vakuumpumpe (4),
• Robotereinheit zum Transport des Objekts in und/oder aus dem Vakuumprozessvolumen, oder
• Stifthubvorrichtung, insbesondere Pin-Lifter, zur Bereitstellung des Objekts in einen Bearbeitungszustand, insbesondere Bearbeitungsposition.

11. Vakuumprozesssystem nach Anspruch 10,
**dadurch gekennzeichnet, dass**
durch die Ansteuerung der als Prozessgasbereitstellungseinheit ausgebildeten Periphereinheit (2,4,21-25) eine definierte Gasmenge für einen Prozesszyklus in dem Vakuumprozessvolumen (1) bereitstellbar ist und damit der definierte Prozesszustand zumindest teilweise bereitstellbar ist.

12. Vakuumprozesssystem nach einem der Ansprüche 1 bis 11, **dadurch gekennzeichnet, dass**
die Regel- und Steuerungseinheit (11) verbunden ist
• mit einem Drucksensor (3) und ein Ausgangssignal des Drucksensors die aktuell bestimmte Regelgrösse (12) bereitstellt, und/oder
• mit einem Massenströmungsmesser (2) oder einer Massenströmungskontrolleinheit (2) und ein Ausgangssignal des Massenströmungsmesser bzw. der Massenströmungskontrolleinheit die aktuell bestimmte Regelgrösse (12) bereitstellt.

13. Regel- und Steuerungseinheit (11) für ein Vakuumprozesssystem, wobei das Vakuumprozesssystem zumindest aufweist
• ein evakuierbares Vakuumprozessvolumen (1), in welches ein Objekt zu dessen Bearbeitung einbringbar ist,
• ein Vakuumventil (10), das zur Regelung eines Volumen- oder Massenstroms und/oder zum gasdichten Abschluss des Vakuumprozessvolumens (1) ausgebildet ist und einen mittels einer Antriebseinheit (40) verstellbaren Ventilverschluss aufweist, und
• eine zur zumindest teilweisen Bereitstellung eines definierten Prozesszustandes in dem Vakuumprozessvolumen (1) ausgebildete Periphereinheit (2,4,21-25),
**dadurch gekennzeichnet, dass**
die Regel- und Steuerungseinheit (11) zur mehrfachen Ausführung eines Prozesszyklus ausgebildet und konfiguriert ist, mit
• einer derartigen Ansteuerung der Periphereinheit (2,4,21-25), dass zumindest ein Teil des definierten Prozesszustands bereitstellbar ist, und
• einer Ausführung eines eine gezielte Variation bzw. Einstellung des Ventilöffnungszustands bereitstellenden Regelzyklus durch Ansteuerung der Antriebseinheit (40) basierend auf einer aktuell bestimmten Regelgrösse (12) für einen Prozessparameter und basierend auf einer Zielgrösse (13), insbesondere wodurch die Regelgrösse (12) an die Zielgrösse (13) durch eine so bewirkte Zustandsänderung des Ventilverschlusses (38) annäherbar ist,
wobei die Ansteuerung der Periphereinheit (2,4,21-25) und die Ausführung des Regelzyklus im Rahmen des Prozesszyklus mit einer bestimmten zeitlichen Relation durchführbar sind.

14. Verfahren zur Durchführung eines Prozesszyklus mit einem Vakuumprozesssystem, wobei das Vakuumprozesssystem zumindest aufweist
• ein evakuierbares Vakuumprozessvolumen (1), in welches ein Objekt zu dessen Bearbeitung einbringbar ist,
• ein Vakuumventil (10), das zur Regelung eines Volumen- oder Massenstroms und/oder zum gasdichten Abschluss des Vakuumprozessvolumens (1) ausgebildet ist und einen mittels einer Antriebseinheit verstellbaren Ventilverschluss aufweist, und
• eine zur zumindest teilweisen Bereitstellung eines definierten Prozesszustandes in dem Vakuumprozessvolumen (1) ausgebildete Periphereinheit (2,4,21-25),
wobei im Rahmen des Verfahrens ein Prozesszyklus, insbesondere mehrfach, ausgeführt wird, und der Prozesszyklus zumindest umfasst
• ein derartiges Ansteuern der Periphereinheit (2,4,21-25), dass zumindest ein Teil des definierten Prozesszustands bereitgestellt wird, und
• ein Ausführen eines eine gezielte Variation bzw. Einstellung des Ventilöffnungszustands bereitstellenden Regelzyklus durch Ansteuern der Antriebseinheit (40) basierend auf einer aktuell bestimmten Regelgrösse (12) für einen Prozessparameter und basierend auf einer Zielgrösse (13), insbesondere wodurch die Regelgrösse (12) an die Zielgrösse (13) durch eine so bewirkte Zustandsänderung des Ventilverschlusses (38) annäherbar ist,
wobei das Ansteuern der Periphereinheit (2,4,21-25) und das Ausführen des Regelzyklus im Rahmen des Prozesszyklus mit einer bestimmten zeitlichen Relation durchgeführt werden.

15. Computerprogrammprodukt, das auf einem maschinenlesbaren Träger gespeichert ist, insbesondere in einer Regel- und Steuerungseinheit nach einem der Ansprüche 1 bis 13, mit Programmcode zur Durchführung bzw. Steuerung zumindest der folgenden Schritte des Verfahrens nach Anspruch 14:
• ein Ansteuern der Periphereinheit (2,4,21-25) und
• ein Ausführen des Regelzyklus mit einem geregelten Variieren bzw. Einstellen des Ventilöffnungszustands,
insbesondere wobei das Programm in einer elektronischen Datenverarbeitungseinheit, insbesondere der Regel- und Steuerungseinheit (11), eines Vakuumprozesssystems nach einem der Ansprüche 1 bis 13 ausgeführt wird.
